# EUROPÄISCHE PATENTSCHRIFT

(11) **EP 2 697 485 B1**
(45) Veröffentlichungstag und Bekanntmachung des Hinweises auf die Patenterteilung: **14.09.2016**
(21) Anmeldenummer: 12715042.3
(22) Anmeldetag: 05.04.2012
(51) Int. Cl.: F01N 3/04, F01N 5/02, F02G 5/02, F28F 13/06, F28D 7/16, F28D 21/00, H01L 35/30

(54) **VORRICHTUNG MIT EINEM WÄRMETAUSCHER FÜR EINEN THERMOELEKTRISCHEN GENERATOR EINES KRAFTFAHRZEUGS**
DEVICE HAVING A HEAT EXCHANGER FOR A THERMOELECTRIC GENERATOR OF A MOTOR VEHICLE
DISPOSITIF DOTÉ D'UN ÉCHANGEUR DE CHALEUR POUR UN GÉNÉRATEUR THERMOÉLECTRIQUE D'UN VÉHICULE AUTOMOBILE

(30) Priorität: 13.04.2011 DE 102011016886
(43) Veröffentlichungstag der Anmeldung: 19.02.2014
(73) Patentinhaber: Continental Automotive GmbH, 30165 Hannover (DE)
(72) Erfinder: LIMBECK, Sigrid, 53804 Much (DE); BRÜCK, Rolf, 51429 Bergisch Gladbach (DE)
(86) Internationale Anmeldenummer: PCT/EP2012/056332
(87) Internationale Veröffentlichungsnummer: WO 2012/139978

(56) Entgegenhaltungen:
- EP-A1- 1 033 481
- EP-A2- 1 455 079
- WO-A1-2010/023118
- WO-A1-2010/057779
- WO-A2-2008/068632
- DE-U1-202004 013 882
- JP-A- 2000 018 095
- US-A- 3 884 297
- US-A1- 2005 284 623

## Beschreibung

Die vorliegende Erfindung betrifft eine Vorrichtung mit einem Wärmetauscher für einen thermoelektrischen Generator, insbesondere zur Anordnung im Bereich des Unterbodens eines Kraftfahrzeugs.

Das Abgas aus einer Verbrennungskraftmaschine eines Kraftfahrzeugs besitzt thermische Energie, welche mittels des thermoelektrischen Generators in elektrische Energie umgewandelt werden soll, bspw. um eine Batterie oder einen anderen Energiespeicher zu füllen und/oder elektrischen Verbrauchern die benötigte Energie direkt zuzuführen. Damit steht für den Betrieb des Kraftfahrzeugs Energie in größerem Umfang zur Verfügung. Durch den Einsatz eines thermoelektrischen Generators wird der energetische Wirkungsgrad einer Verbrennungskraftmaschine weiter erhöht.

Ein solcher thermoelektrischer Generator weist zumeist eine Mehrzahl, ggf. modulartiger, thermoelektrischer Wandlerelemente auf. Thermoelektrische Materialien sind von einer Art, dass diese effektiv thermische Energie in elektrische Energie umwandeln können (Seebeck-Effekt) und umgekehrt (Peltier-Effekt). Der Seebeck-Effekt basiert auf dem Phänomen der Umwandlung von Wärmeenergie in elektrische Energie und wird zur Erzeugung thermoelektrischer Energie benutzt. Der Peltier-Effekt ist die Umkehrung des Seebeck-Effekts und ein Phänomen, welches mit Wärmeadsorption einhergeht und in Relation zu einem Stromfluss durch unterschiedliche Materialen verursacht wird. Der Peltier-Effekt ist bspw. zum thermoelektrischen Kühlen bereits vorgeschlagen worden.

Solche thermoelektrischen Wandlerelemente weisen bevorzugt eine Vielzahl von thermoelektrischen Elementen auf, die zwischen einer sogenannten Warmseite und einer sogenannten Kaltseite positioniert sind. Thermoelektrische Elemente umfassen z. B. wenigstens zwei Halbleiterquader (p-dotiert und n-dotiert), die auf ihrer Ober- und Unterseite (hin zur heißen Seite bzw. kalten Seite) wechselseitig mit elektrisch leitenden Brücken verbunden sind. Keramikplatten bzw. Keramikbeschichtungen, aber auch Kunststoffe und/oder ähnliche Materialien dienen zur Isolierung der Metallbrücken und sind somit bevorzugt zwischen den Metallbrücken angeordnet. Wird ein Temperaturgefälle beidseits der Halbleiterquader bereitgestellt, so bildet sich ein Spannungspotential. Auf der einen Kontaktstelle wird dabei Wärme aufgenommen (Heißseite), wobei die Elektronen der einen Seite auf das energetisch höher liegende Leitungsband des folgenden Quaders gelangen. Auf der anderen Seite können die Elektronen nun Energie freisetzen, um wieder auf ein niedrigeres Energieniveau zu gelangen (Kaltseite). Somit kann sich bei einem entsprechenden Temperaturgefälle ein Stromfluss einstellen.

Bei der Auslegung von thermoelektrischen Generatoren und deren Einsatz in einem Kraftfahrzeug sind verschiedenste Herausforderungen zu bewältigen. Unter anderem sind innerhalb der thermoelektrischen Wandlerelemente gute Wärmeübergänge bereitzustellen, so dass die vorliegenden Temperaturunterschiede effizient zur Umwandlung in elektrische Energie umgewandelt werden können. Weiterhin ist in einem unter verschiedensten Lastbedingungen arbeitenden Abgassystem einer Verbrennungskraftmaschine ein für die thermoelektrischen Elemente geeignetes Temperaturniveau bereitzustellen. Unter diesen Gesichtspunkten ist auch die Anordnung der thermoelektrischen Elemente innerhalb einer derartigen Vorrichtung bzw. eines Abgassystems zu beachten. Die Anordnung eines die thermoelektrischen Elemente umfassenden thermoelektrischen Generators ist dahingehend problematisch, dass auf der einen Seite möglichst viel Wärme aus dem Abgas für die Erzeugung elektrischer Energie genutzt werden soll und eine entsprechende motornahe Anordnung damit vorteilhaft wäre, wobei auf der anderen Seite die beengten Platzverhältnisse und die zulässigen maximalen Temperaturen berücksichtigt werden müssen.

Die WO-A1-2010/023118 betrifft einen radial durchströmbaren Wabenkörper, der innerhalb und außerhalb dieses Wabenkörpers axial verlaufende Wärmetauscherrohre aufweist. Das Abgas wird über radial verlaufenden Strömungskanäle zu den Wärmetauscherrohren geführt.

Die US 3,884,297 betrifft einen in radialer Richtung von einem Abgas durchströmbaren Wärmetauscher. Wärmetauscherrohre verlaufen in axialer Richtung. Das Abgas tritt durch einen zentralen Kanal in den Wärmetauscher ein und wird dort umgelenkt, so dass es in radialer Richtung die axial verlaufenden Wärmetauscherrohre überströmt. Das Abgas wird dabei durch in axialer Richtung hintereinander eingebaute Scheibenelemente so aufgeteilt, dass über die axiale Länge ein möglichst gleichmäßig verteilter Abgasstrom in radialer Richtung vorliegt..

Aus der WO-A1-2010/057779 ist ein radial durchströmbarer Wabenkörper mit axial dazu verlaufenden Wärmetauscherrohren bekannt.

Die DE-U1-20 2004 013 882 betrifft einen Wärmetauscher, der plattenförmige durchströmbare Elemente aufweist, die quer zu deren Durchströmungsrichtung und quer zu den Platten von Wärmetauscherrohren durchschnitten werden. Auf den Platten sind Leitelemente vorgesehen, die die Wirbelbildung unterstützen und dabei den Druckverlust möglichst gering halten sollen.

Die WO-A2-2008/068632 ist auf einen Wärmetauscher gerichtet, bei dem eine Abgasleitung an einer Stirnseite verschließbar ist, so dass entsprechend das Abgas über Öffnungen in der Abgasleitung um einen radial außen liegenden Wärmetauscher strömen kann.

Die JP 2000-18095 beschreibt eine Abgasleitung, die von thermoelektrischen Elementen umgeben ist.

Aufgabe der vorliegenden Erfindung ist es demnach, die mit Bezug auf den Stand der Technik geschilderten Probleme zumindest teilweise zu lösen. Insbesondere soll eine Vorrichtung angegeben werden, die in allen Betriebspunkten einer Verbrennungskraftmaschine zum Einsatz kommen kann und eine hohe Effizienz bei der Umwandlung von thermischer Energie aus dem Abgas aufweist. Darüber hinaus soll die Vorrichtung einen möglichst platzsparenden Aufbau aufweisen und insbesondere zur Anordnung im Bereich des Unterbodens eines Kraftfahrzeugs geeignet sein. Weiterhin soll auch ein nachträglicher Einbau der Vorrichtung in ein Kraftfahrzeug möglich sein, ohne dass aufwendige Maßnahmen zur Integration erforderlich sind.

Diese Aufgaben werden mit einer Vorrichtung gemäß den Merkmalen des Patentanspruchs 1 gelöst. Vorteilhafte Ausgestaltungen der erfindungsgemäßen Vorrichtung sind in den abhängig formulierten Patentansprüchen angegeben. Es ist darauf hinzuweisen, dass die in den Patentansprüchen einzeln aufgeführten Merkmale in beliebiger, technologisch sinnvoller, Weise miteinander kombiniert werden können und weitere Ausgestaltungen der Erfindung aufzeigen. Die Beschreibung, insbesondere im Zusammenhang mit den Figuren, erläutert die Erfindung weiter und führt ergänzende Ausführungsbeispiele der Erfindung an.

Die Vorrichtung hat einen Wärmetauscher, insbesondere zur Anordnung in einer Abgasanlage einer Verbrennungskraftmaschine in einem Kraftfahrzeug, der zumindest ein Gehäuse mit einem Einlass und einem Auslass für ein Fluid aufweist. Weiter weist der Wärmetauscher ein inneres Rohr mit einer axialen Richtung, einer ersten Stirnseite und einer gegenüberliegenden zweiten Stirnseite sowie einer ersten Umfangsfläche mit Öffnungen auf. Zudem ist eine Mehrzahl von Wärmetauscherrohren vorgesehen, die parallel zur axialen Richtung außen an der ersten Umfangsfläche angeordnet sind. Das Gehäuse umgibt die Wärmetauscherrohre und das innere Rohr. Der Einlass ist mit der ersten Stirnseite strömungstechnisch verbunden. Es sind weiterhin Leitelemente so zwischen den Wärmetauscherrohren angeordnet, dass das Fluid, das über die erste Stirnseite in das innere Rohr eintritt, in radialer Richtung ausgehend von dem inneren Rohr die Wärmetauscherrohre überströmt und dann in einen, in radialer Richtung zwischen Wärmetauscherrohren und Gehäuse liegenden, Abströmkanal überführt wird. Erst im Abströmkanal wird das Fluid in eine Strömungsrichtung in axialer Richtung umgelenkt, wobei der Abströmkanal mit dem Auslass strömungstechnisch verbunden ist.

Das Gehäuse ist bevorzugt rund, insbesondere kreisförmig oder auch elliptisch/oval geformt, aber keineswegs auf eine solche Form beschränkt. Das Fluid, insbesondere ein Abgas der Verbrennungskraftmaschine, strömt über den Einlass in das Gehäuse und über die erste Stirnseite in axialer Richtung in das innere Rohr ein. Das innere Rohr ist auf seiner Umfangsfläche mit Öffnungen versehen. Die zweite Stirnseite des inneren Rohrs ist insbesondere verschließbar ausgeführt, so dass das Fluid durch die Öffnungen in der ersten Umfangsfläche des inneren Rohrs in einer radialen Richtung aus dem inneren Rohr austritt. Außerhalb der ersten Umfangsfläche des inneren Rohrs sind Leitelemente vorgesehen, die sich insbesondere in der axialen Richtung und in der radialen Richtung erstrecken, so dass das Fluid, insbesondere ausschließlich, in radialer Richtung die Leitelemente und die hier angeordneten Wärmetauscherrohre überströmt und damit in radialer Richtung strömend in den Abströmkanal eintritt. Der Abströmkanal umgibt insbesondere vollumfänglich das innere Rohr bzw. die Leitelemente und Wärmetauscherrohre. Hier wird das Fluid in eine axiale Richtung erneut umgelenkt und strömt insbesondere entlang des Gehäuses in Richtung des Auslasses.

Durch die, insbesondere ausschließlich, radiale Überströmung der Wärmetauscherrohre wird ein gleichmäßiger Wärmeübergang an den Wärmetauscherrohren erzeugt, so dass insbesondere keine nennenswerten Temperaturunterschiede auf der Außenfläche der Wärmetauscherrohre vorliegen. Insbesondere beträgt der maximale Temperaturunterschied auf der von dem Fluid überströmten Außenfläche der Wärmetauscherrohre in Umfangsrichtung und in der axialen Erstreckung der Wärmetauscherrohre höchstens 30 Kelvin, insbesondere höchstens 15 Kelvin, bevorzugt höchstens 10 Kelvin und besonders bevorzugt höchstens 5 Kelvin. Hierdurch erfolgt eine gleichmäßige Belastung der Wärmetauscherrohre hinsichtlich thermischer Gradienten und thermischer Ausdehnung.

Insbesondere sind die Öffnungen auf der ersten Umfangsfläche des Innenrohrs so verteilt, dass eine gleichmäßige Strömungsverteilung über die erste Umfangsfläche des inneren Rohrs vorherrscht. Eine nicht gleichmäßige Durchströmung der ersten Umfangsfläche des inneren Rohres resultiert aus einer ungleichmäßigen Druckverteilung im inneren Rohr. Diese ungleichmäßige Druckverteilung ist in erster Linie darauf zurückzuführen, dass das Fluid auf eine verschlossene oder zumindest teilweise verschlossene zweite Stirnseite des Innenrohrs auftrifft und an dieser Stelle ein höherer Staudruck entsteht, so dass hier der Durchsatz an Fluid durch die erste Umfangsfläche größer wäre als im Bereich der offenen ersten Stirnseite. Durch die Anpassung der Anzahl und/oder Größe und/oder Gestalt der Öffnungen auf der ersten Umfangsfläche wird eine gleichmäßige Strömungsverteilung eingestellt. Das heißt auch, dass die gleiche Fluidmenge je Flächenanteil die erste Umfangsfläche des inneren Rohrs durchströmt. Insbesondere sind im Bereich der ersten Stirnseite des inneren Rohrs größere Öffnungen und/oder eine höhere Anzahl von Öffnungen auf der ersten Umfangsfläche vorgesehen. Den Öffnungen können (teilweise) auch (jeweils eine oder mehrere) Leitstrukturen (Hutzen, Flügel, Schaufeln, etc.) zugeordnet sein, die nach dem Durchtritt des Fluids durch die Öffnung das Fluid hin zu den Wärmetauscherrohren führen, bündeln, fokussieren, etc.

Die erste Umfangsfläche des inneren Rohres ist insbesondere zumindest zu 75 % offen, das heißt, 75 % der ersten Umfangsfläche wird durch Öffnungen in der ersten Umfangsfläche gebildet. Dabei dienen die Öffnungen insbesondere auch zur Strömungsverteilung, so dass die außen an der ersten Umfangsfläche angeordneten Wärmetauscherrohre entsprechend angeströmt werden. Hierdurch wird ein verbesserter Wärmeübergang vom Fluid auf die Wärmetauscherrohre ermöglicht und ein übermäßiger Druckverlust verhindert. Die Öffnungen weisen insbesondere einen größten Durchmesser von höchstens 6 mm [Millimeter] auf.

Gemäß einer vorteilhaften Ausgestaltung des Wärmetauschers ist der Auslass mit der zweiten Stirnseite strömungstechnisch verbunden, wobei die zweite Stirnseite zumindest teilweise verschließbar ist, so dass ein Fluidstrom über die erste Umfangsfläche einerseits und über die zweite Stirnseite andererseits, kontrollierbar ist. Insbesondere ist im Bereich der zweiten Stirnseite eine gezielt ansteuerbare und/oder bewegliche Klappe angeordnet, so dass das Fluid bei einer vollständig oder teilweise geschlossenen Klappe nicht oder teilweise über die erste Umfangsfläche strömt. Bei einer vollständig offenen Stellung der Klappe kann das Fluid im Wesentlichen vollständig über die zweite Stirnseite in Richtung des Auslasses des Gehäuses strömen. Dies ist insbesondere dann erforderlich, wenn die Abgastemperatur zu hoch ist, so dass die Wärmetauscherrohre nicht ausreichend gekühlt werden können, bzw. wenn die Kühlung nicht zusätzlich belastet werden soll. Weiterhin kann somit auch der Wärmeeintrag an stromabwärts angeordneten Abgasbehandlungseinheiten gesteuert werden, indem nur ein regelbarer Wärmeverlust durch die Überströmung der Wärmetauscherrohre erfolgt. Die thermische Energie bleibt also im Fluid gespeichert und wird erst stromabwärts des Wärmetauschers an zusätzlich angeordnete Abgasbehandlungseinheiten in einer Abgasleitung abgegeben. Zudem kann bei erhöhtem Fluiddurchsatz die zweite Stirnseite zumindest teilweise geöffnet werden, so dass ein Druckverlust, der beim Durchströmen des Wärmetauschers entsteht, hierdurch gering gehalten wird.

Die Kontrolle und/oder Einstellung der verschließbaren zweiten Stirnseite der zweiten Stirnseite erfolgt bevorzugt unter Berücksichtigung des Betriebspunktes der Verbrennungskraftmaschine bzw. unter Berücksichtigung von Kennwerten des Fluids (Temperatur, Druck, Fluidzusammensetzung). Dazu kann eine Regelung vorgesehen sein, die den Anteil an Fluid steuert, der über die zweite Stirnseite bzw. über die erste Umfangsfläche des inneren Rohrs strömt.

Gemäß einer vorteilhaften Ausgestaltung der Vorrichtung sind thermoelektrische Elemente in den Wärmetauscherrohren vorgesehen. Die thermoelektrischen Elemente sind dabei insbesondere ringförmig in der axialen Richtung des Wärmetauscherrohrs aufeinander gestapelt. Die Wärmetauscherrohre werden außen von dem heißen Fluid (Abgas) überströmt und durch einen inneren Kanal von einem Kühlfluid (Wasser) durchströmt. Durch den so entstehenden Temperaturgradienten zwischen der Außenfläche und innerem Kanal des Wärmetauscherrohrs wird durch die elektrisch verschalteten thermoelektrischen Elemente ein elektrischer Strom erzeugt, der am Gehäuse des Wärmetauschers über geeignete elektrische Anschlüsse abgegriffen werden kann. Die Vorrichtung mit dem Wärmetauscher wird somit als thermoelektrischer Generator betrieben, der insbesondere mit elektrischen Speichern oder elektrischen Verbrauchern des Kraftfahrzeugs verbunden ist, so dass hierbei der durch den thermoelektrischen Generator erzeugte Strom dem Kraftfahrzeug zur Verfügung gestellt werden kann.

Infolge der praktisch (nahezu) ausschließlichen radialen Überströmung der Wärmetauscherrohre ist es hier möglich, gleichartige thermoelektrische Materialien für die thermoelektrischen Elemente innerhalb der Wärmetauscherrohre einzusetzen, weil kein (ausgeprägter) Temperaturgradient entlang der ersten Umfangsfläche des Innenrohrs und/oder an der vom Fluid überströmten Außenfläche der Wärmetauscherrohre vorliegt. Damit kann ein einfacher Aufbau des thermoelektrischen Generators gewährleistet werden und die Erzeugung elektrischer Energie ist mit hoher Effizienz möglich.

Als thermoelektrische Materialien für die thermoelektrischen Elemente kommen insbesondere die folgenden in Frage:

| | |
|---|---|
| n-dotiertes thermoelektrisches Material: | Silicide (z.B. MgSi-MgSn) |
| p-dotiertes thermoelektrisches Material: | Zintl-Phasen (z.B. Zn₄Sb₄) |

Diese Materialien haben sich als besonders vorteilhaft erwiesen und ermöglichen eine effiziente Umwandlung der thermischen Energie des heißen Fluids (Abgas) in elektrische Energie. Bei den Siliciden handelt es sich insbesondere um binäre metallische Verbindungen des Siliciums, die als Halbleiter genutzt werden können. Bei den Zintl-Phasen handelt es sich insbesondere um intermetallische Verbindungen zwischen stark elektropositiven Alkalimetallen oder Erdalkalimetallen und mäßig elektronegativen Elementen aus der 13. bis 16. Gruppe des Periodensystems. Einige Zintl-Phasen sind diamagnetische Halbleiter, deren Leitfähigkeit im Gegensatz zu metallischen Leitern mit steigender Temperatur ansteigt.

Bei der erfindungsgemäßen Vorrichtung ist ein äußeres Rohr vorgesehen, das sich um das innere Rohr und die Wärmetauscherrohre herum erstreckt und eine zweite Umfangsfläche mit Öffnungen aufweist, wobei die Leitelemente mit dem inneren Rohr und/oder dem äußeren Rohr verbunden sind. Die Verbindung ist hierbei insbesondere stoffschlüssig ausgeführt. Die Ausführungen zum inneren Rohr gelten entsprechend für das äußere Rohr.

Insbesondere erstreckt sich das äußere Rohr vollumfänglich um das innere Rohr herum, so dass die Wärmetauscherrohre im Zwischenraum zwischen innerem Rohr und äußeren Rohr angeordnet sind. Durch die Anordnung des äußeren Rohrs können die Leitelemente zwischen den Wärmetauscherrohren besonders vorteilhaft angeordnet werden, weil so eine Fixierung der Leitelemente einerseits an dem inneren Rohr und andererseits auf dem äußeren Rohr ermöglicht wird. Insbesondere kann das innere Rohr und das äußere Rohr zusammen mit den Leitelementen und den Wärmetauscherrohren - aber auch ohne Wärmetauscherrohre - als Einheit vormontiert und bereitgestellt werden, so dass die Öffnungen am inneren Rohr (und am äußeren Rohr) in Bezug auf die Leitelemente und auf die Wärmetauscherrohre entsprechend ausgerichtet positioniert sind. Eine richtige Positionierung beinhaltet hier eine strömungstechnisch angepasste Anordnung, so dass die Leitelemente die Öffnungen auch nicht teilweise verschließen und ein Druckverlust des über die erste Umfangsfläche eintretenden bzw. über die zweite Umfangsfläche austretenden Fluids gering gehalten wird.

Gemäß einer Weiterentwicklung wird auch vorgeschlagen, dass zumindest ein Leitelement aus mindestens einer metallischen Folie hergestellt ist. Die metallische Folie ist insbesondere mindestens 12 µm und höchstens 120 µm [Mikrometer] dick und besteht bevorzugt aus einem Chrom und Nickel enthaltenem Stahl. Das Leitelement ist insbesondere an dem inneren Rohr und/oder an dem äußeren Rohr stoffschlüssig durch eine Lötverbindung oder Schweißverbindung verbunden, so dass eine dauerfeste und temperaturfeste Anordnung des Leitelements ermöglicht ist. Bevorzugt sind jeweils zwei Leitelemente zwischen jeweils zwei in Umfangsrichtung gesehen benachbart zueinander angeordneten Wärmetauscherrohren vorgesehen.

Insbesondere ist das zumindest eine Leitelement mit einem Abstand von 2 bis 7 mm [Millimeter] zu einem Wärmetauscherrohr angeordnet. Durch diesen Abstand ergibt sich eine vorteilhafte Aufteilung des Fluidstroms über die verfügbare Außenfläche der Wärmetauscherrohre. Insbesondere weisen die Wärmetauscherrohre einen größten Durchmesser von 25 bis 35 mm [Millimeter] auf, insbesondere bis höchstens 30 mm. Insbesondere sind die Wärmetauscherrohre mit einer Distanz in Umfangsrichtung von 4 bis 14 mm [Millimeter] voneinander beabstandet.

Gemäß einer weiteren Ausgestaltung sind zumindest ein Leitelement und/oder zumindest ein Wärmetauscherrohr mit Strukturen zur Erzeugung von Turbulenzen in der Fluidströmung ausgestattet. Diese Strukturen können durch eine erhöhte Rauheit und/oder durch Mikrostrukturen und/oder durch die Form der Leitstrukturen gebildet sein. Diese Strukturen erzeugen Turbulenzen innerhalb des Fluidstroms um das Wärmetauscherrohr, so dass ein Wärmeübergang vom Fluidstrom zum Wärmetauscherrohr verbessert wird. Damit wird dem Fluidstrom ein erhöhter Anteil an Wärmeenergie entzogen und über die Wärmetauscherrohre abgeführt. Damit ist ein effizienterer Einsatz des Wärmetauschers bzw. des thermoelektrischen Generators hier möglich. Gemäß einer besonders vorteilhaften Ausgestaltung ist (zusätzlich oder alternativ) zumindest ein Wärmetauscherrohr mit Strukturen zur Erzeugung von Turbulenzen in der Fluidströmung auf seiner Außenfläche ausgestattet, wobei hier vergleichbare Strukturen zum Einsatz kommen wie am Leitelement. Insbesondere sind diese am Wärmetauscherrohr und am Leitelement angeordnet und hinsichtlich ihrer Positionierung und strömungstechnischen Wirkung aufeinander abgestimmt.

Insbesondere sind die Mikrostrukturen in der Form von Noppen und/oder Dellen ausgeführt. Die Noppen erstrecken sich ausgehend von der Oberfläche des Leitelements/ Wärmetauscherrohrs nach außen, die Dellen erstrecken sich nach innen.

Insbesondere werden die Strukturen durch eine erhöhte Rauheit gebildet. Die Rauheit der Oberfläche des Wärmetauscherrohrs, die dem Fluidstrom zugewandt ist, ist dabei erhöht gegenüber der Rauheit an der Oberfläche des Wärmetauscherrohrs, die den thermoelektrischen Elementen oder dem Kühlfluid zugewandt ist. Insbesondere ist die Rauheit an der dem Fluidstrom zugewandten Seite des Wärmetauscherrohrs um einen Faktor von mindestens 5 erhöht, bevorzugt von mindestens 10 und besonders bevorzugt von mindestens 20. Die Rauheit wird als mittlere Rauheit Ra oder gemittelte Rautiefe Rz ermittelt. Die Verfahren zur Ermittlung der Rauheits-Kennwerte sind dem Fachmann aus internationalen Normen bekannt, z. B. aus der DIN EN ISO 4287.

Gemäß einer weiteren vorteilhaften Ausgestaltung ist der Druckverlust in der Fluidströmung zwischen innerem Rohr und Abströmkanal um mindestens den Faktor 5, insbesondere um den Faktor 10, größer als der Druckverlust zwischen einem ersten Ende des Abströmkanals und dem Auslass des Gehäuses. Dabei wird der Druckverlust der Fluidströmung zwischen innerem Rohr und Abströmkanal im inneren Rohr an einer beliebigen Stelle entlang der Mittelachse des inneren Rohrs und im Abströmkanal an einem vom Messpunkt im inneren Rohr ausgehend in radialer Richtung liegenden Punkt im Abströmkanal gemessen. Die Messpunkte für den Druckverlust zwischen einem ersten Ende des Abströmkanals und dem Auslass des Gehäuses werden an einem Punkt nahe der geschlossenen Seite des Abströmkanals im Bereich des Einlasses bzw. der ersten Stirnseite gemessen und im Bereich der Mittelachse des Gehäuses im Auslass. Durch dieses Verhältnis soll ausgedrückt werden, dass das Fluid im Abströmkanal und in dem weiteren Strömungsbereich bis hin zum Auslass des Gehäuses keiner nennenswerten Strömungsbehinderung ausgesetzt ist und damit hier nur einen geringen Druckverlust erfährt. Der eigentliche Druckverlust erfolgt bei der Überströmung der Wärmetauscherrohre und ist hiermit auch ein Kriterium für den Wärmeübergang zwischen Fluid und Wärmetauscherrohren. Dies resultiert in erster Linie daraus, dass der Druckverlust dadurch entsteht, dass das Fluid durch die in der Strömungsrichtung des Fluids angeordneten Wärmetauscherrohre behindert wird. Das Fluid beaufschlagt die Wärmetauscherrohre und wird um diese herumgeleitet. Durch die Öffnungen im inneren Rohr und ggf. im äußeren Rohr wird eine möglichst gleichmäßige Verteilung des Fluidstroms über die verfügbare Außenfläche der Wärmetauscherrohre erreicht. Diese Maßnahmen führen einerseits dazu, dass ein höherer Druckverlust in diesem Bereich entsteht, anderseits wird dadurch eine Optimierung des Wärmeübergangs zwischen Fluid und Wärmetauscherrohren erreicht. Dieses Verhältnis gilt insbesondere für den Fall, dass als Fluid Abgas eingesetzt wird, ein mittlerer Volumenstrom des Abgases, der bei Kraftfahrzeugen üblich ist, angesetzt wird, die Temperatur des Abgases in einem Bereich von 200 bis 600°C liegt und das gesamte Abgas über die Öffnungen des inneren Rohres geleitet wird.

Gemäß einer vorteilhaften Ausgestaltung der Vorrichtung erstreckt sich zumindest ein Leitelement über einen Winkelbereich von mindestens 120 um ein Wärmetauscherrohr herum. Damit soll insbesondere ausgedrückt werden, dass bevorzugt alle Leitelemente das Abgas bzw. das Fluid um die Außenfläche des Wärmetauscherrohrs herumleiten. Durch die radiale Ausströmung des Fluids aus dem inneren Rohr vergrößert sich mit zunehmendem Radius ausgehend von der Mittelachse des inneren Rohrs die verfügbare Querschnittsfläche, über die das Fluid in Richtung Abströmkanal strömt. Diese sich vergrößernde Querschnittsfläche wird nun durch die Leitelemente und gleichzeitig durch die an der ersten Umfangsfläche des Innenrohrs angeordneten Wärmetauscherrohre eingeschränkt. Dabei wird das Fluid an der Außenfläche der Wärmetauscherrohre entlang geführt, so dass hier ein möglichst guter Wärmeübergang zwischen Fluid und Wärmetauscherrohr erfolgt. Aus diesem Grund ist ein möglichst großer Winkelbereich des Wärmetauscherrohrs durch das Leitelement abgedeckt, so dass in diesem Bereich eine Führung des Fluids erfolgt. Insbesondere erfolgt diese Abdeckung des Wärmetauscherrohrs durch einen Winkelbereich auf zwei Seiten des Wärmetauscherrohrs, so dass insgesamt mindestens 240 des Wärmetauscherrohrs durch die Leitelemente abgedeckt sind. Insbesondere bezieht sich dieser Winkelbereich auf den Bereich des Leitelements, der in einem Abstand von 2 bis 7 mm, insbesondere 2 bis 12 mm, von der Außenfläche des Wärmetauscherrohrs beabstandet ist.

Besonders vorteilhaft ist es auch, wenn zumindest ein Leitelement in einem konstanten Abstand gegenüber einem benachbarten Wärmetauscherrohr angeordnet ist. Dabei ist der Abstand zwischen einer Außenfläche des Wärmetauscherrohrs und einem Leitelement insbesondere konstant in Bezug auf die Erstreckung der Wärmetauscherrohre bzw. des Leitelements in der axialen Richtung. Insbesondere bezieht sich dieser konstante Abstand zusätzlich auch auf das Leitelement und auf das Wärmetauscherrohr in radialer Richtung. Dadurch soll ausgedrückt werden, dass in einem möglichst großen Bereich der Außenfläche des Wärmetauscherrohrs das Fluid oberflächennah am Wärmetauscherrohr vorbeigeführt wird, so dass hier eine besonders gute Wärmeübertragung vom Fluid auf das Wärmetauscherrohr ermöglicht wird. Ganz besonders bevorzugt ist, dass mit allen Leitelementen und allen Wärmetauscherrohren ein gleichbleibender Abstand eingehalten ist.

Insbesondere ist mindestens ein Wärmetauscherrohr zumindest teilweise nicht kreisrund ausgebildet ist. Vielmehr ist bevorzugt, dass sich mindestens ein Wärmetauscherrohr zumindest teilweise (in einem axialen Abschnitt) in der radialen Richtung verjüngt. Das Wärmetauscherrohr ist insbesondere zumindest teilweise elliptisch geformt, wobei sich der größere Durchmesser in der radialen Richtung erstreckt. Insbesondere ist mindestens ein Wärmetauscherrohr zumindest teilweise flügelförmig geformt. Ganz besonders bevorzugt ist weiter, dass (nahezu) alle Abschnitte, die mit dem Abgas in Kontakt kommen, bei allen Wärmetauscherrohren eine entsprechende Anpassung der Gestalt aufweisen.

Insbesondere weist mindestens ein Wärmetauscherrohr zumindest teilweise ein elliptisches Profil und/oder ein flügelförmiges Profil auf. Bevorzugt ist bei einem flügelförmigen Wärmetauscherrohr, dass die gerundete, dickere erste Seite hin zum inneren Rohr orientiert und die dünn auslaufende zweite Seite in radialer Richtung hin zum Abströmkanal ausgerichtet sind. Durch eine solche, nicht-kreisrunde Form der Wärmetauscherrohre wird der Druckverlust durch eine verbesserte Umströmung gesenkt und der Wärmeübergang vom Fluid auf die Wärmetauscherrohre in der radialen Richtung vergleichmäßigt. Das heißere Fluid prallt in Strömungsrichtung nach radial außen zuerst auf die dickere Seite der Wärmetauscherrohre, so dass hier einerseits ein sehr guter Wärmeübergang und andererseits eine gute Wärmeabführung innerhalb des Wärmetauscherrohres erfolgt. In Strömungsrichtung nach radial außen umströmt das Fluid die Wärmetauscherrohre, so dass der Wärmeübergang geringer ist. Infolge einer Reduzierung des Querschnitts des Wärmetauscherrohres auf dieser radial außen liegenden Seite (bei elliptischer oder flügelartiger Form) wird auch weniger Wärme (durch ein Kühlfluid) an dieser Seite des Wärmetauscherrohrs abgeführt. Somit wird das Verhältnis von Wärmeübergang und Wärmeabführung über den Umfang des Wärmetauscherrohres vergleichmäßigt.

Bei einer elliptischen Ausprägung eines Wärmetauscherrohres entspricht der Verlauf der Rohrwand in einem betrachteten Querschnitt des Wärmetauscherrohres etwa einer Ellipse. Dabei sind gegenüberliegende Verläufe der Rohrwand mit (etwa) demselben Krümmungsradius ausgeführt, während um 90 versetzte Verläufe einen unterschiedlichen Krümmungsradius ausbilden. Bei einer flügelförmigen Ausprägung eines Wärmetauscherrohres wird von der Rohrwand im betrachteten Querschnitt ebenfalls ein eher länglicher Raum eingeschlossen, wobei hier die Abschnitte der kleinsten Krümmungsradien verschieden ausgeführt sind, insbesondere ist einer der beiden Endabschnitte gekrümmt und der andere bildet eine Art Kante aus. Bei einer flügelförmigen Ausprägung eines Wärmetauscherrohres kann auch ein (beidseits ohne Strömungsabriss arbeitender) Flügel ausgebildet sein.

Insbesondere sind Strukturen an Leitelementen und/oder an den Wärmetauscherrohren so angepasst angeordnet, dass Turbulenzen zwischen Leitelement und Wärmetauscherrohr im Fluid erzeugt werden. Damit wird der Wärmeübergang auch bei einer elliptischen oder flügelartigen Form des Wärmetauscherrohres in diesem Bereich deutlich verbessert.

Insbesondere kann bei dem Wärmetauscher innerhalb des inneren Rohrs ein von dem Fluid radial durchströmbarer Wabenkörper angeordnet werden. Dieser ist insbesondere katalytisch beschichtet. Der Wabenkörper erstreckt sich dabei bevorzugt über die gesamte Umfangsfläche des inneren Rohrs. Der Wabenkörper kann einen zentrisch angeordneten Kanal aufweisen, der zur ersten Stirnseite und zur zweiten Stirnseite offen ausgeführt ist. Das Fluid strömt folglich über die erste Stirnseite in den Kanal ein und wird, je nach Stellung der stromabwärts der zweiten Stirnseite angeordneten Klappe, zumindest durch die radial verlaufenden Strömungspfade des Wabenkörpers in Richtung des inneren Rohrs umgelenkt. Das innere Rohr umgibt den Wabenkörper bevorzugt unmittelbar und ist insbesondere mit diesem zumindest kraftschlüssig oder aber auch stoffschlüssig verbunden.

Stoffschlüssige Verbindungen werden in diesem Zusammenhang alle Verbindungen genannt, bei denen die Verbindungspartner durch atomare und/oder molekulare Kräfte zusammengehalten werden. Sie sind gleichzeitig nicht lösbare Verbindungen, die sich nur durch Zerstörung der Verbindungsmittel trennen lassen (z. B. durch Schweißen oder Löten erzeugte Verbindungen). Kraftschlüssige Verbindungen setzen eine Normalkraft auf die miteinander zu verbindenden Flächen voraus. Ihre gegenseitige Verschiebung ist verhindert, solange die durch die Haftreibung bewirkte Gegenkraft nicht überschritten wird.

Die Erfindung findet insbesondere Anwendung bei einem Kraftfahrzeug mit einer Verbrennungskraftmaschine und einer Abgasbehandlungsvorrichtung sowie einer in der Abgasleitung angeordneten erfindungsgemäßen Vorrichtung, wobei das Fluid ein Abgas der Verbrennungskraftmaschine ist. Insbesondere können natürlich mehrere Wärmetauscher in einer einsträngigen oder auch mehrsträngigen Abgasleitung vorgesehen sein.

Die Erfindung sowie das technische Umfeld werden nachfolgend anhand der Figuren näher erläutert. Die Figuren zeigen besonders bevorzugte Ausführungsbeispiele, auf die die Erfindung jedoch nicht begrenzt ist. Es zeigen schematisch:
- Fig. 1:: eine Vorrichtung mit einem Wärmetauscher im Längsschnitt,
- Fig. 2:: eine weitere Ausführungsvariante der Vorrichtung im Längsschnitt,
- Fig. 3:: die Vorrichtung aus Fig. 2 im Querschnitt,
- Fig. 4:: das Detail aus Fig. 3 in Vergrößerung, und
- Fig. 5:: eine beispielhafte Anordnung einer solchen Vorrichtung in einem Kraftfahrzeug.

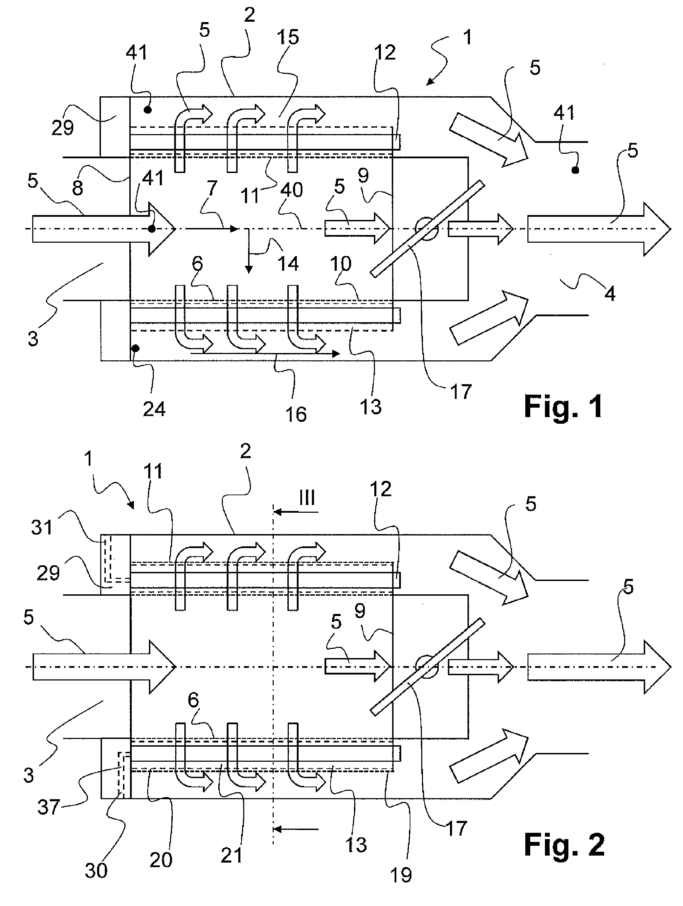

Fig. 1 zeigt einen Wärmetauscher 1 in einem Längsschnitt. Das Fluid 5 (bzw. Abgas) strömt durch den Einlass 3 und durch die strömungstechnisch mit dem Einlass 3 verbundene erste Stirnseite 8 in axialer Richtung 7 in das innere Rohr 6 des Wärmetauschers 1 ein. Hier wird der Fluidstrom zumindest teilweise umgelenkt, so dass das Fluid 5 nun in der radialen Richtung 14 in Richtung der ersten Umfangsfläche 10 des inneren Rohrs 6 strömt. Das Fluid 5 durchtritt die erste Umfangsfläche 10 durch Öffnungen 11 und beaufschlagt die außen an der ersten Umfangsfläche 10 angeordneten Wärmetauscherrohre 12. Zwischen den Wärmetauscherrohren 12 sind Leitelemente 13 angeordnet, die das Fluid 5 um die Wärmetauscherrohre 12 herum führen. Das Fluid 5 tritt in radialer Richtung 14 strömend in den außen die Wärmetauscherrohre 12 umgebenden Abströmkanal 15 ein, der selbst außen durch das Gehäuse 2 begrenzt wird. Hier wird das Fluid 5 erneut umgelenkt in die axiale Richtung 7 und strömt durch den Abströmkanal 15 in Richtung des Auslasses 4. In dieser Fig. 1 ist der Abströmkanal 15 in der axialen Richtung 7 zylindrisch ausgeführt. Eine konische Ausführung ist entsprechend auch möglich, z. B. indem sich das Gehäuse 2 in Richtung des Auslasses 4 entlang dem Abströmkanal 15 erweitert.

Das Fluid 5 kann das innere Rohr 6 auch entlang der Mittelachse 40 des inneren Rohrs in der axialen Richtung 7 über die zweite Stirnseite 9 verlassen, wobei hier eine Klappe 17 angeordnet ist, die die zweite Stirnseite 9 des inneren Rohrs 6 zumindest teilweise verschließen kann. Das Fluid 5 strömt stromabwärts der zweiten Stirnseite 9 in Richtung des Auslasses 4.

Es ist zu erkennen, dass das Fluid 5 das innere Rohr 6 über die Öffnungen 11 in einer radialen Richtung 14 verlässt. Diese Richtung behält das Fluid 5 auch beim Überströmen der Wärmetauscherrohre 12 bei, wobei hier durch die Umlenkung um die Wärmetauscherrohre 12 auch eine Richtungskomponente in Umfangsrichtung vorliegt. Erst innerhalb des Abströmkanals 15 erfolgt die erneute Umlenkung des Fluids 5 in eine axiale Richtung 7. Die Strömungsrichtung 16 des Fluidstroms in dem Abströmkanal 15 ist hier im unteren Teil der Fig. 1 dargestellt. Der Abströmkanal 15 erstreckt sich von einem ersten Ende 24 im Bereich des Einlasses 3 bzw. im Bereich der ersten Stirnseite 8 bis zum Auslass 4. Das innere Rohr 6 erstreckt sich von der ersten Stirnseite 8 bis zur zweiten Stirnseite 9 und ist auf seiner gesamten ersten Umfangsfläche 10 mit geregelt angeordneten Öffnungen 11 versehen, so dass unter Berücksichtigung z. B. des erhöhten Staudrucks im Bereich der zweiten Stirnseite 9 bei geschlossener Klappe 17 eine gleichmäßige Abströmung des Fluids 5 über die erste Umfangsfläche 10 erfolgt.

Im Bereich des Einlasses 3 bzw. der ersten Stirnseite 8 ist am Gehäuse 2 eine Verschlussplatte 29 vorgesehen. Diese dient einerseits zur Begrenzung des Abströmkanals 15, der nur in Richtung des Auslasses 4 geöffnet und andererseits zur Aufnahme der Wärmetauscherrohre 12, so dass hier ein das Wärmetauscherrohr 12 durchströmende Kühlfluid zu- und abgeführt wird. Die Wärmetauscherrohre 12 erstrecken sich ausgehend von der Verschlussplatte 29 entlang der ersten Umfangsfläche 10 hin bis zur zweiten Stirnseite 9. Dort ist eine Umlenkung vorgesehen, durch die ein Kühlfluid durch ein weiteres Wärmetauscherrohr 12 zur Verschlussplatte 29 zurückgeführt wird. Gleichzeitig können in der Verschlussplatte 29 elektrische Anschlüsse (nicht gezeigt) vorgesehen sein, so dass ein infolge des Temperaturunterschieds zwischen heißem Fluid 5 und kaltem Kühlfluid innerhalb der Wärmetauscherrohre 12 erzeugten elektrischen Stroms, infolge der Anordnung von thermoelektrischen Elementen innerhalb der Wärmetauscherrohre, zum Kraftfahrzeug abgeführt werden kann.

Der Druckverlust des Fluidstroms innerhalb des Wärmetauschers 1 wird beispielsweise an den gezeigten Messpunkten 41 ermittelt.

Fig. 2 zeigt eine zweite Ausführungsvariante des Wärmetauschers 1 ebenfalls in einem Längsschnitt. Dabei sind gleiche Komponenten des Wärmetauschers 1 mit gleichen Bezugszeichen versehen wie in Fig. 1. Die weitere Ausführungsvariante des Wärmetauschers 1 unterscheidet sich durch die Anordnung eines äußeren Rohrs 19, das die Leitelemente 13 und die Wärmetauscherrohre 12 umgibt. Durch die Anordnung des äußeren Rohrs 19 können die Leitelemente 13, die hier durch metallische Folien 21 gebildet sind, sowohl am inneren Rohr 6 als auch am äußeren Rohr 19 angebunden werden und deswegen mechanisch stabilisiert werden. Weiter sind hier in der Verschlussplatte 29 ein Zulauf 30 und ein Rücklauf 31 für ein Kühlfluid 37 für die Wärmetauscherrohre 12 gezeigt.

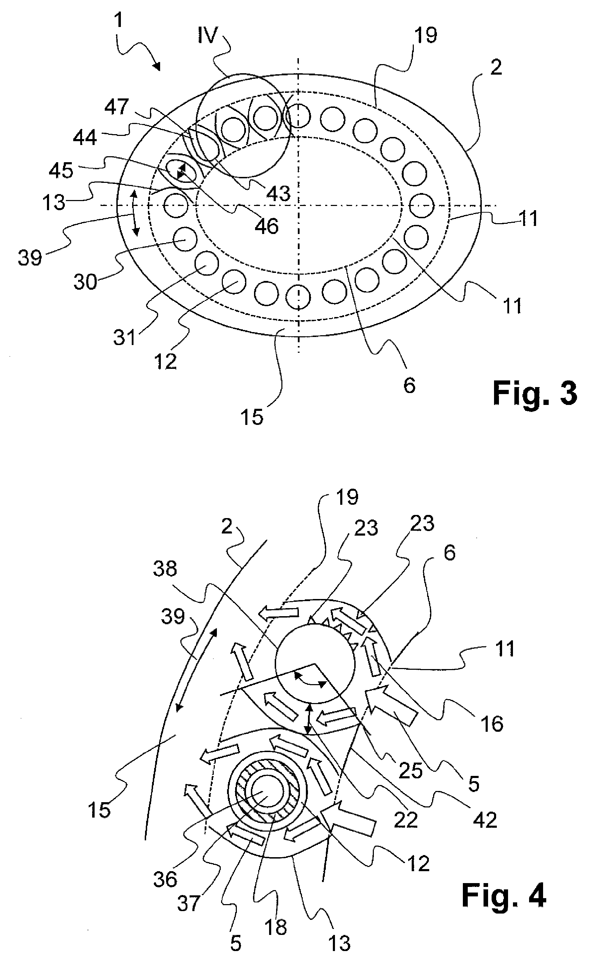

Fig. 3 zeigt die weitere Ausführungsvariante des Wärmetauschers 1 gemäß Fig. 2 im Querschnitt entlang der in Fig. 2 gezeigten Schnittachse (III). Das Gehäuse 2 umschließt den Abströmkanal 15, das äußere Rohr 19, die Wärmetauscherrohre 12 mit dazwischen angeordneten Leitelementen 13 und das innere Rohr 6. Das innere Rohr 6 und das äußere Rohr 19 weisen jeweils Öffnungen 11 auf, durch die das Fluid vom inneren Rohr 6 über die Wärmetauscherrohre 12 hin zum Abströmkanal 15 strömen kann. In Fig. 3 ist ein Ausschnitt (IV) gekennzeichnet, der in Fig. 4 näher erläutert wird.

In Fig. 3 ist erkennbar, dass zumindest einzelne Wärmetauscherrohre 12 elliptisch oder flügelartig geformt sind. Die dicke, gerundete erste Seite 43 des flügelförmigen Profils 44 ist dabei hin zu dem inneren Rohr 6 orientiert. Die dünne zweite Seite 47 ist radial außen hin zum Abströmkanal 15 angeordnet. Bei dem elliptischen Profil 45 ist der kleinere Durchmesser 46 parallel zur Umfangsrichtung 39 angeordnet. Durch diese Profile 44, 45 wird das Fluid 5 um die Wärmetauscherrohre 12 herumgelenkt, wobei insbesondere ein geringerer Druckverlust als bei kreisrunden Wärmetauscherrohren 12 entsteht. Durch die Anordnung von Strukturen 23 an den Leitelementen 13 und/oder an den Wärmetauscherrohren 12 (siehe in Fig. 4) wird der Wärmeübergang in dem Bereich zwischen Wärmetauscherrohr 12 und Leitelement 13 verbessert. Die Strukturen 23 können stärkere Turbulenzen mit höherem Druckverlust in diesem Bereich erzeugen als bei kreisrunden Wärmetauscherrohren 12, da der Druckverlust bei der An- und Umströmung der Profile 44, 45 (ohne Strukturen 23) geringer ist.

Fig. 4 zeigt das Detail aus Fig. 3, wobei die Umströmung der Wärmetauscherrohre 12 hier näher erläutert wird. Das Fluid 5 strömt ausgehend vom inneren Rohr 6 durch Öffnungen 11 in den Zwischenraum zwischen innerem Rohr 6 und äußerem Rohr 19. Dabei sind Öffnungen 11 dort vorgesehen, wo Wärmetauscherrohre 12 zwischen Leitelementen 13 angeordnet sind. Die Bereiche 42 des inneren Rohrs 6, die ausschließlich zwischen den Leitelementen 13 angeordnet sind, sind hier verschlossen, so dass an diesen Stellen kein Fluid 5 in diese Bereiche 42 einströmen kann. Die Leitelemente 13 berühren sich hier gegenseitig und stützen sich damit ab. Dies führt zu einer zusätzlichen mechanischen Fixierung der Lage der Leitelemente 13. Das Fluid 5 wird durch die Leitelemente 13 in Strömungsrichtung 16 um die Wärmetauscherrohre 12 herumgeführt. Das Fluid strömt dabei ausschließlich in radialer Richtung 14 und in Umfangsrichtung 39. In den so bereitgestellten Kanälen zwischen Leitelementen 13 und Außenfläche 38 der Wärmetauscherrohre 12 sind Strukturen 23 vorgesehen, die laminare Randströmungen des Fluids 5 auflösen und damit einen verbesserten Wärmeübergang hin zu den Wärmetauscherrohren 12 ermöglichen sollen. Die Leitelemente 13 sind in einem gewissen Abstand 22 zu der Außenfläche 38 der Wärmetauscherrohre 12 angeordnet, dass über einen Winkelbereich 2 5 das Fluid 5 um das Wärmetauscherrohr 12 herumgeführt wird. Erst dadurch wird der verbesserte Wärmeübergang ermöglicht.

Im unteren Teil der Fig. 4 ist ein Wärmetauscherrohr 12 im Querschnitt im Detail dargestellt, wobei hier die ringförmigen thermoelektrischen Elemente 18 innerhalb des Wärmetauscherrohrs 12 gezeigt sind. Das Wärmetauscherrohr 12 weist weiterhin einen inneren Kanal 36 auf, der von einem Kühlfluid 37 durchströmt wird. Das Fluid 5 verlässt die Kanäle zwischen Leitelementen 13 und Wärmetauscherrohren 12 über die Öffnungen 11 des äußeren Rohrs 19 in den Abströmkanal 15. Der Abströmkanal 15 wird außen durch das Gehäuse 2 begrenzt.

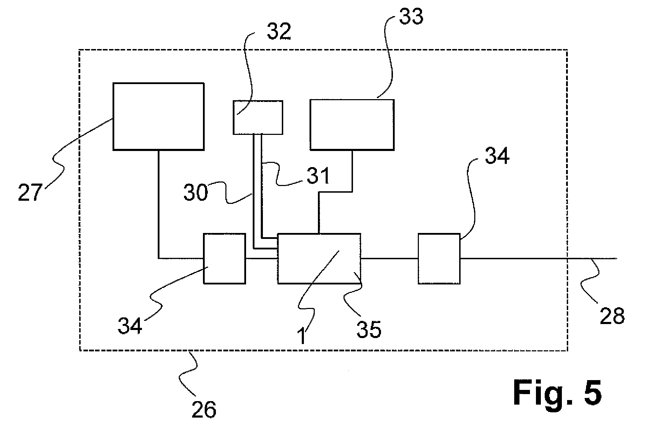

Fig. 5 zeigt die Anordnung des Wärmetauschers 1 innerhalb eines Kraftfahrzeugs 26. Das Kraftfahrzeug 26 weist eine Verbrennungskraftmaschine 27 mit einer Abgasleitung 28 sowie weiteren Abgasbehandlungskomponenten 34 auf. Der Wärmetauscher 1 ist hier als thermoelektrischer Generator 35 ausgeführt, wobei die in dem thermoelektrischen Generator angeordneten Wärmetauscherrohre über einen Zulauf 30 und einen Rücklauf 31 mit einer Kühlung 32 verbunden sind. Weiterhin ist eine Regeleinheit 33 vorgesehen, die unter anderem zur Ansteuerung der Klappe innerhalb des Wärmetauschers 1 dient, so dass die Abgasmenge, die über die erste Umfangsfläche des Innenrohrs bzw. über die zweite Stirnseite strömt, gesteuert werden kann. Damit kann der Bypass für das Fluid an den Wärmetauscherrohren und den thermoelektrischen Elementen vorbei geregelt werden, so dass die Kühlung 32 der Verbrennungskraftmaschine ggf. nicht durch das Abgas im thermoelektrischen Generator 35 zusätzlich beaufschlagt wird.

Andere Ausgestaltungen bzw. Ausführungsvarianten der Erfindung sind möglich. Insbesondere ist es möglich, dass mehrere Verschlussplatten 29 innerhalb des Gehäuses 2 angeordnet sind, so dass die Wärmetauscherrohre 12 nicht nur an einem Ende sondern auch an einem weiteren Ende aufgenommen werden. So kann auch der Zulauf 30 und der Rücklauf 31 jeweils in getrennten Verschlussplatten 29 angeordnet werden, so dass die Durchströmung der Wärmetauscherrohre 12 lediglich in einer axialen Richtung erfolgt. In den hier gezeigten Figuren durchströmt ein Kühlfluid 37 die Wärmetauscherrohre ausgehend von dem Zulauf 30 in der Verschlussplatte 29 in der Nähe des Einlass 3 in einer axialen Richtung 7 bis zur zweiten Stirnseite 9 und zurück hin zum Rücklauf 31 in der Verschlussplatte 29.

### Bezugszeichenliste

- 1: Wärmetauscher
- 2: Gehäuse
- 3: Einlass
- 4: Auslass
- 5: Fluid
- 6: Inneres Rohr
- 7: Axiale Richtung
- 8: Erste Stirnseite
- 9: Zweiten Stirnseite
- 10: Erste Umfangsfläche
- 11: Öffnungen
- 12: Wärmetauscherrohr
- 13: Leitelement
- 14: Radiale Richtung
- 15: Abströmkanal
- 16: Strömungsrichtung
- 17: Klappe
- 18: Thermoelektrisches Element
- 19: Äußeres Rohr
- 20: Zweite Umfangsfläche
- 21: Metallische Folie
- 22: Abstand
- 23: Struktur
- 24: Erstes Ende
- 25: Winkelbereich
- 26: Kraftfahrzeug
- 27: Verbrennungskraftmaschine
- 28: Abgasleitung
- 29: Verschlussplatte
- 30: Zulauf
- 31: Rücklauf
- 32: Kühlung
- 33: Regeleinheit
- 34: Abgasbehandlungskomponente
- 35: Thermoelektrischer Generator
- 36: Innerer Kanal
- 37: Kühlfluid
- 38: Außenfläche
- 39: Umfangsrichtung
- 40: Mittelachse
- 41: Messpunkt
- 42: Bereich
- 43: Erste Seite
- 44: Flügelförmiges Profil
- 45: Elliptisches Profil
- 46: Durchmesser
- 47: Zweite Seite

## Patentansprüche

1. Vorrichtung mit einem Wärmetauscher (1), der zumindest ein Gehäuse (2) mit einem Einlass (3) und einem Auslass (4) für ein Fluid (5) und ein inneres Rohr (6) mit einer axialen Richtung (7), einer ersten Stirnseite (8) und einer gegenüberliegenden zweiten Stirnseite (9) sowie einer ersten Umfangsfläche (10) mit Öffnungen (11) aufweist, weiter einer Mehrzahl von Wärmetauscherrohren (12), die parallel zur axialen Richtung (7) außen an der ersten Umfangsfläche (10) angeordnet sind, wobei das Gehäuse (2) die Wärmetauscherrohre (12) und das innere Rohr (6) umgibt und der Einlass (3) mit der ersten Stirnseite (8) strömungstechnisch verbunden ist, wobei Leitelemente (13) so zwischen den Wärmetauscherrohren (12) angeordnet sind, dass das Fluid (5), das über die erste Stirnseite (8) in das innere Rohr (6) eintritt, in radialer Richtung (14) ausgehend von dem inneren Rohr (6) die Wärmetauscherrohre (12) überströmt und dann in einen, in radialer Richtung (14) zwischen Wärmetauscherrohren (12) und Gehäuse (2) liegenden Abströmkanal (15) überführt wird und dort in eine Strömungsrichtung (16) in axialer Richtung (7) umgelenkt wird, wobei der Abströmkanal (15) mit dem Auslass (4) strömungstechnisch verbunden ist; wobei ein äußeres Rohr (19) vorgesehen ist, das sich um das innere Rohr (6) und die Wärmetauscherrohre (12) herum erstreckt und eine zweiten Umfangsfläche (20) mit Öffnungen (11) aufweist, wobei die Leitelemente (13) mit dem inneren Rohr (6) und/oder dem äußeren Rohr (19) verbunden sind.

2. Vorrichtung gemäß Patentanspruch 1, wobei die zweite Stirnseite (9) verschließbar ist, so dass ein Fluidstrom über die Umfangsfläche (10) und über die zweite Stirnseite (9) regelbar ist.

3. Vorrichtung nach einem der vorhergehenden Patentansprüche, wobei thermoelektrische Elemente (18) in den Wärmetauscherrohren (12) angeordnet sind.

4. Vorrichtung nach einem der vorhergehenden Patentansprüche, wobei zumindest ein Leitelement (13) aus mindestens einer metallischen Folie (21) hergestellt ist.

5. Vorrichtung nach einem der vorhergehenden Patentansprüche, wobei zumindest ein Leitelement (13) mit einem Abstand (22) von 2 bis 7 mm zu einem Wärmetauscherrohr (12) angeordnet ist.

6. Vorrichtung nach einem der vorhergehenden Patentansprüche, wobei zumindest ein Leitelement (13) und/oder zumindest ein Wärmetauscherrohr (12) mit Strukturen (23) zur Erzeugung von Turbulenzen in der Fluidströmung ausgestattet ist.

7. Vorrichtung nach einem der vorhergehenden Patentansprüche, wobei ein Druckverlust der Fluidströmung zwischen innerem Rohr (6) und Abströmkanal (15) um mindestens einen Faktor 5 größer ist als ein Druckverlust zwischen einem ersten Ende (24) des Abströmkanals (15) und dem Auslass (4) des Gehäuses (2).

8. Vorrichtung nach einem der vorhergehenden Patentansprüche, wobei zumindest ein Leitelement (13) sich über einen Winkelbereich (25) von mindestens 120° um ein Wärmetauscherrohr (12) herum erstreckt.

9. Vorrichtung nach einem der vorhergehenden Patentansprüche, wobei zumindest ein Leitelement (13) in einem konstanten Abstand (22) gegenüber einem benachbarten Wärmetauscherrohr (12) angeordnet ist.

10. Vorrichtung nach einem der vorhergehenden Patentansprüche, wobei mindestens ein Wärmetauscherrohr (12) zumindest teilweise ein flügelförmiges Profil (44) oder ein elliptisches Profil (45) aufweist.

11. Kraftfahrzeug (26) aufweisend eine Verbrennungskraftmaschine (27) und eine Abgasleitung (28) und eine in der Abgasleitung (28) angeordnete Vorrichtung nach einem der vorhergehenden Patentansprüche, wobei das Fluid (5) ein Abgas der Verbrennungskraftmaschine (27) ist.

## Claims

1. Device having a heat exchanger (1) which has at least one housing (2) with an inlet (3) and an outlet (4) for a fluid (5) and has an inner tube (6) with an axial direction (7), with a first end side (8) and with an opposite second end side (9) and with a first circumferential surface (10) which has openings (11), also having a multiplicity of heat exchanger tubes (12) which are arranged, parallel to the axial direction (7), at the outside on the first circumferential surface (10), wherein the housing (2) surrounds the heat exchanger tubes (12) and the inner tube (6), and the inlet (3) is connected in terms of flow to the first end side (8), wherein guide elements (13) are arranged between the heat exchanger tubes (12) such that the fluid (5) which enters the inner tube (6) via the first end side (8) flows over the heat exchanger tubes (12) in a radial direction (14) proceeding from the inner tube (6) and is then passed into an outflow duct (15) situated between heat exchanger tubes (12) and housing (2) as viewed in the radial direction (14), and there, is diverted into a flow direction (16) in the axial direction (7), wherein the outflow duct (15) is connected in terms of flow to the outlet (4), wherein an outer tube (19) is provided which extends around the inner tube (6) and the heat exchanger tubes (12) and has a second circumferential surface (20) with openings (11), wherein the guide elements (13) are connected to the inner tube (6) and/or to the outer tube (19).

2. Device according to Patent Claim 1, wherein the second end side (9) can be closed such that a fluid stream via the circumferential surface (10) and via the second end side (9) can be controlled.

3. Device according to one of the preceding patent claims, wherein thermoelectric elements (18) are arranged in the heat exchanger tubes (12).

4. Device according to one of the preceding patent claims, wherein at least one guide element (13) is produced from at least one metallic foil (21).

5. Device according to one of the preceding patent claims, wherein at least one guide element (13) is arranged with a spacing (22) of 2 to 7 mm to a heat exchanger tube (12).

6. Device according to one of the preceding patent claims, wherein at least one guide element (13) and/or at least one heat exchanger tube (12) is equipped with structures (23) for generating turbulence in the fluid flow.

7. Device according to one of the preceding patent claims, wherein a pressure loss of the fluid flow between the inner tube (6) and outflow duct (15) is greater by at least a factor of 5 than a pressure loss between a first end (24) of the outflow duct (15) and the outlet (4) of the housing (2).

8. Device according to one of the preceding patent claims, wherein at least one guide element (13) extends around a heat exchanger tube (12) over an angle region (25) of at least 120°.

9. Device according to one of the preceding patent claims, wherein at least one guide element (13) is arranged with a constant spacing (22) with respect to an adjacent heat exchanger tube (12).

10. Device according to one of the preceding patent claims, wherein at least one heat exchanger tube (12) at least partially has a wing-shaped profile (44) or an elliptical profile (45).

11. Motor vehicle (26) having an internal combustion engine (27) and having an exhaust line (28) and having a device according to one of the preceding patent claims arranged in the exhaust line (28), wherein the fluid (5) is an exhaust gas of the internal combustion engine (27).

## Revendications

1. Dispositif doté d'un échangeur de chaleur (1), qui présente au moins un corps (2) avec une entrée (3) et une sortie (4) pour un fluide (5) et un tube intérieur (6) avec une direction axiale (7), une première face frontale (8) et une deuxième face frontale opposée (9) ainsi qu'une première surface périphérique (10) avec des ouvertures (11), avec en outre une multiplicité de tubes d'échangeur de chaleur (12), qui sont disposés à l'extérieur sur la première surface périphérique (10) parallèlement à la direction axiale (7), dans lequel le corps (2) entoure les tubes d'échangeur de chaleur (12) et le tube intérieur (6) et l'entrée (3) est connectée en relation d'écoulement à la première face frontale (8), dans lequel des éléments de guidage (13) sont disposés entre les tubes d'échangeur de chaleur (12) de telle manière que le fluide (5), qui pénètre dans le tube intérieur (6) par la première face frontale (8), balaie les tubes d'échangeur de chaleur (12) en direction radiale (14) à partir du tube intérieur (6) et soit ensuite transféré dans un canal d'évacuation (15) situé en direction radiale (14) entre des tubes d'échangeur de chaleur (12) et le corps (2) et y soit dévié dans une direction d'écoulement (16) en direction axiale (7), dans lequel le canal d'évacuation (15) est en relation d'écoulement avec la sortie (4), dans lequel il est prévu un tube extérieur (19), qui s'étend autour du tube intérieur (6) et des tubes d'échangeur de chaleur (12) et qui présente une deuxième surface périphérique (20) avec des ouvertures (11), dans lequel les éléments de guidage (13) sont assemblés au tube intérieur (6) et/ou au tube extérieur (19).

2. Dispositif selon la revendication 1, dans lequel la deuxième face frontale (9) peut être fermée, de telle manière qu'un courant de fluide sur la surface périphérique (10) et sur la deuxième face frontale (9) soit réglable.

3. Dispositif selon l'une quelconque des revendications précédentes, dans lequel des éléments thermoélectriques (18) sont disposés dans les tubes d'échangeur de chaleur (12).

4. Dispositif selon l'une quelconque des revendications précédentes, dans lequel au moins un élément de guidage (13) est fabriqué à partir d'au moins une feuille métallique (21).

5. Dispositif selon l'une quelconque des revendications précédentes, dans lequel au moins un élément de guidage (13) est disposé à une distance (22) de 2 à 7 mm d'un tube d'échangeur de chaleur (12).

6. Dispositif selon l'une quelconque des revendications précédentes, dans lequel au moins un élément de guidage (13) et/ou au moins un tube d'échangeur de chaleur (12) est doté de structures (23) destinées à produire des turbulences dans l'écoulement de fluide.

7. Dispositif selon l'une quelconque des revendications précédentes, dans lequel une perte de pression de l'écoulement de fluide entre le tube intérieur (6) et le canal d'évacuation (15) est plus élevée d'au moins un facteur 5 qu'une perte de pression entre une première extrémité (24) du canal d'évacuation (15) et la sortie (4) du corps (2).

8. Dispositif selon l'une quelconque des revendications précédentes, dans lequel au moins un élément de guidage (13) s'étend sur une plage angulaire (25) d'au moins 120° autour d'un tube d'échangeur de chaleur (12).

9. Dispositif selon l'une quelconque des revendications précédentes, dans lequel au moins un élément de guidage (13) est disposé à une distance constante (22) par rapport à un tube d'changeur de chaleur voisin (12).

10. Dispositif selon l'une quelconque des revendications précédentes, dans lequel au moins un tube d'échangeur de chaleur (12) présente au moins en partie un profil en forme d'ailette (44) ou un profil elliptique (45).

11. Véhicule automobile (26) présentant un moteur à combustion interne (27) et un tuyau de gaz d'échappement (28) et un dispositif selon l'une quelconque des revendications précédentes disposé dans le tuyau de gaz d'échappement (28), dans lequel le fluide (5) est un gaz d'échappement du moteur à combustion interne (27).
